(19) Europäisches Patentamt
European Patent Office
Office européen des brevets

(11) **EP 1 523 697 B1**

(12) **EUROPÄISCHE PATENTSCHRIFT**

(45) Veröffentlichungstag und Bekanntmachung des Hinweises auf die Patenterteilung:
**05.12.2007 Patentblatt 2007/49**

(21) Anmeldenummer: 03765041.3

(22) Anmeldetag: **18.07.2003**

(51) Int Cl.:
***G03F 7/00*** *(2006.01)*

(86) Internationale Anmeldenummer:
**PCT/EP2003/007819**

(87) Internationale Veröffentlichungsnummer:
**WO 2004/010222 (29.01.2004 Gazette 2004/05)**

(54) **VERFAHREN ZUR HERSTELLUNG VON PHOTOLACKSTRUKTUREN**

METHOD FOR THE PRODUCTION OF PHOTORESIST STRUCTURES

PROCEDE DE PRODUCTION DE STRUCTURE DE LAQUE PHOTOSENSIBLE

(84) Benannte Vertragsstaaten:
**AT BE BG CH CY CZ DE DK EE ES FI FR GB GR HU IE IT LI LU MC NL PT RO SE SI SK TR**

(30) Priorität: **22.07.2002 DE 10233309**

(43) Veröffentlichungstag der Anmeldung:
**20.04.2005 Patentblatt 2005/16**

(73) Patentinhaber: **Forschungszentrum Karlsruhe GmbH**
**76133 Karlsruhe (DE)**

(72) Erfinder:
• **MEISEL, Daniel**
**76646 Bruchsal (DE)**
• **MIKLIAEV, Iouri**
**Tschelljabinsk 454025 (RU)**
• **WEGENER, Martin**
**76127 Karlsruhe (DE)**

(74) Vertreter: **Rückert, Friedrich**
**Forschungszentrum Karlsruhe GmbH**
**Patente und Lizenzen**
**Weberstrasse 5**
**76133 Karlsruhe (DE)**

(56) Entgegenhaltungen:
**EP-A- 0 421 645     EP-A- 0 795 803**
**WO-A-01/13181     GB-A- 1 289 095**
**US-A- 3 635 540     US-A- 3 832 565**

**Beschreibung**

Die Erfindung betrifft Verfahren zur Herstellung von Strukturen in einem Volumen aus Photolack (Photolackvolumen).

Die US 3,635,540 A und die GB 1 289 095 A offenbaren jeweils ein Verfahren zur Herstellung von Hologrammen mit zwei Lichtstrahlen, die sich in einem Volumen überlagern, wobei diese zuvor durch ein transparentes optisches Element in Form eines Vielflächners (Prisma, Rhombus) laufen.

Um Photolackstrukturen herzustellen, wird entsprechend der in der WO 01/22133 A1 beschriebenen sogenannten holographischen Lithographie ein photoempfindliches Material mit einem Vielstrahl-Interferenzmuster, das aus der Überlagerung mehrerer Lichtstrahlen resultiert, belichtet und anschließend entwickelt. Die Form der so erzeugten Photolackstrukturen hängt im Allgemeinen von den Winkeln der interferierenden Lichtstrahlen im Inneren des Photolackes ab. Zum Ein- oder Auskoppeln der Lichtstrahlen wird dort die Verwendung eines transparenten optischen Elementes sowie nötigenfalls die Verwendung von Immersionssubstanz zwischen festen optischen Elementen vorgeschlagen.

Der Erfindung liegt die Aufgabe zugrunde, eine größere Vielfalt an Photolackstrukturen herzustellen.

Gelöst wird diese Aufgabe durch die Merkmale des Patentanspruchs 1 und des Patentanspruchs 3. Die Unteransprüche beschreiben vorteilhafte Ausgestaltungen der Erfindung.

Bei der Einstrahlung von Lichtstrahlen in ein Photolackvolumen aus einem äußeren Medium (z. B. Luft) mit geringerer Brechzahl als Photolack ist der Bereich realisierbarer Ausbreitungsrichtungen der Lichtstrahlen im Inneren des Photolackvolumens in unerwünschter Weise eingeschränkt. Der Grund hierfür besteht darin, dass beim Übergang vom äußeren, optisch dünneren Medium in den Photolack die Brechung der Strahlen zu berücksichtigen ist, die sich durch Wahl der Einstrahlrichtung, wie in der WO 01/22133 A1 vorgeschlagen, nur begrenzt kompensieren lässt.

Der maximal erreichbare Brechungswinkel eines Strahles bei Einstrahlung aus dem äußeren Medium ist der Grenzwinkel der Totalreflexion, der bei Luft und typischen Photolacken einen Wert von ca. 36° annimmt. Dieser Wert würde streifenden Einfall erfordern. Winkel im Inneren des Photolacks, die größer als der Grenzwinkel der Totalreflexion sind, lassen sich durch Wahl der Einstrahlrichtung daher nicht einstellen.

Zunächst wird ein Photolackvolumen mit zwei, drei, vier, fünf, sechs oder mehr Lichtstrahlen belichtet, die sich innerhalb des Photolackvolumens so überlagern, dass darin ein Interferenzmuster erzeugt wird, wobei im Falle von zwei Lichtstrahlen mindestens zwei Belichtungen des Photolackvolumens vorgesehen sind, zwischen denen die Lichtstrahlen (und das Photolackvolumen relativ zueinander bewegt werden. Im Falle von drei oder mehr Lichtstrahlen können ebenfalls zwei oder mehr Belichtungen des Photolackvolumens durchgeführt werden, zwischen denen die Lichtstrahlen (und das Photolackvolumen relativ zueinander bewegt werden. Anschließend wird dieses Photolackvolumen einem Entwicklungsprozess unterworfen, wodurch eine dem Interferenzmuster entsprechende Photolackstruktur erzeugt wird.

Erfindungsgemäß werden die zwei, drei, vier, fünf, sechs oder mehr teilkohärenten Lichtstrahlen über einen Vielflächner in das Photolackvolumen hinein oder aus dem Photolackvolumen heraus geführt. Dadurch wird es möglich, Strahlwinkel im Inneren des Photolackes jenseits des Grenzwinkels der Totalreflexion zugänglich zu machen, d. h. Winkel zwischen den Strahlen im Inneren des Photolackes, die bei direkter Einstrahlung aus dem äußeren Medium nicht zugänglich sind. Bei Luft als äußeres Medium ist dieses der beträchtliche Wertebereich zwischen ca. 36° und 90°.

Darüber hinaus werden auch bei Brechungswinkeln unterhalb, insbesondere auch in der Nähe des Grenzwinkels der Totalreflexion, durch die Verwendung eines Vielflächners die Einkopplung und die Auskopplung der Lichtstrahlen wesentlich verbessert.

Erfindungsgemäß werden die optischen Elemente als Vielflächner, vorzugsweise als Teilprisma, bevorzugt als Pyramide, besonders bevorzugt als Pyramidenstumpf, oder in einer weiteren Ausgestaltung als Kugelabschnitt ausgestaltet.

Um den Übergang der Strahlen vom optischen Element in das Photolackvolumen zu ermöglichen, kann der Photolack direkt auf das optische Element aufgebracht werden. In einer anderen Ausgestaltung wird eine Immersionssubstanz zwischen das optische Element und das Photolackvolumen eingebracht. Wird der Photolack in flüssigem Zustand belichtet, kann die Immersionssubstanz gegebenenfalls entfallen.

Ein besonderer Vorteil des erfindungsgemäßen Verfahrens besteht darin, dass nicht nur einige ausgewählte, sondern alle Bravais-Gitter hergestellt werden können. Dies gilt insbesondere für die im Hinblick auf eine dreidimensionale vollständige Bandlücke interessante kubisch flächenzentrierte (fcc) Struktur (siehe K. Busch, S. John, PRE 1998, 58, S. 3896).

Der Brechzahlunterschied zwischen Luft und Photolack (1 bzw. 1,6 bei Photolack SU-8) reicht vermutlich jedoch nicht aus, um eine vollständige dreidimensionale Bandlücke im Photonischen Kristall zu erzielen. Durch Auffüllen (Infiltration) der Poren der Photolackstruktur (Templat, verlorene Form) mit einem transparenten und stark - brechenden Material und nachfolgendem Entfernen des Photolackes kann die komplementäre Struktur aus hochbrechendem Material hergestellt werden. Hierzu ist erforderlich, dass sowohl die Poren als auch das Photolack-Gerippe jeweils zusammenhängend sind. Die Poren müssen miteinander verbunden sein, damit zum einen der unpolymerisierte Photolack herausgelöst werden kann und zum anderen die Poren anschließend durchgängig mit hochbrechendem Material befüllt (infiltriert) werden können. Die Photolackstruktur muss zusammenhängend sein, damit sie mechanisch stabil ist und nicht auseinander fällt.

Es wird darauf hingewiesen, dass in der WO 01/22133 A1 zwar versucht wurde, fcc-Strukturen mit dem so genannten Vielstrahl-Interferenz-Verfahren mittels Einstrahlung von Lichtstrahlen direkt aus Luft herzustellen. Im Innern des Photolacks entstand aufgrund der Brechung an der Luft-Photolack-Grenzfläche tatsächlich jedoch keine fcc-Struktur, sondern vielmehr eine andere Struktur, die nach gegenwärtigem Kenntnisstand für Anwendungen als Templat für Photonische Kristalle mit vollständiger dreidimensionaler Bandlücke nicht geeignet ist.

Erfindungsgemäße Photolackstrukturen eignen sich darüber hinaus als Effektbeschichtung von Oberflächen, als Partikelfilter, als Mikromischer, als Volumengitter, als Beugungsstruktur oder dispersive Struktur, als Photonischer Kristall oder als verlorene Form für einen Photonischen Kristall.

Im Folgenden wird die Erfindung mit Hilfe der Figuren beschrieben. Es zeigt

**Fig. 1**    die Realisierung von Strahlwinkeln in einem Photolack über den Grenzwinkel der Totalreflexion hinaus und

**Fig. 2**    einen schematischen Schichtaufbau für das Verfahren.

Durch die Brechung an der Luft-Photolack-Grenzfläche wird ein Lichtstrahl mit dem Einfallswinkel $\alpha$ **10** zur Oberflächennormale (Lot) des Photolackes **9** in den Photolack **9** gemäß dem Snelliusschen Brechungsgesetz

$$\sin(\alpha) = n_{Photolack} \times \sin(\gamma)$$

gebrochen, wobei $\gamma$ **11** den Winkel des gebrochenen Lichtstrahles bezüglich der Oberflächennormalen im Innern des Photolacks bezeichnet. Für den verwendeten Photolack betrug bei der Belichtung n ≈ 1,67.

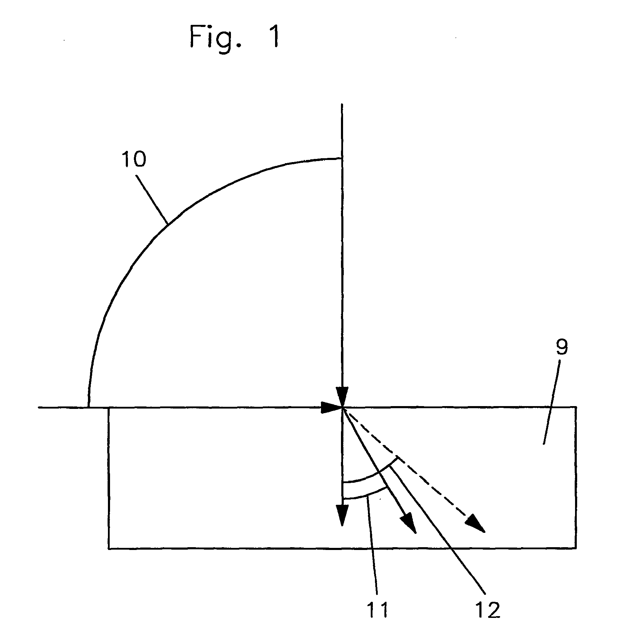

Bei einer Vierstrahl-Konfiguration in so genannter regenschirmartiger Anordnung (umbrella-like configuration)(siehe K. I. Petsas et al., Phys. Rev. A 1994, 50, Seite 5173) liegen, wie in **Fig. 1** dargestellt, drei der Strahlen - im Folgenden Nebenstrahlen genannt - bzw. deren Wellenvektoren gleichmäßig verteilt auf einem Kegelmantel, wobei alle drei Wellenvektoren zur Spitze des Kegels hin zeigen. Ein weiterer Strahl - im Folgenden Referenzstrahl genannt - liegt auf der Achse des Kegels und weist ebenso zur Spitze des Kegels hin. Der Referenzstrahl bildet das Einfallslot zur Photolackschicht. Um mit dieser Strahlenkonfiguration z. B. eine Struktur mit fcc-Translationssymmetrie herzustellen, muss der Winkel zwischen den Nebenstrahlen und dem Referenzstrahl im Inneren des Photolackes $\gamma_{fcc}$ = arccos (7/9) ≈ 38, 94° betragen.

Dessen Realisierung steht zunächst die Totalreflexion entgegen, denn der Grenzwinkel der Totalreflexion $\gamma_{Grenz}$ **11** für den Photolack SU-8 beträgt $\gamma_{Grenz}$ = arcsin (1/n$_{Photolack}$) ≈ 36,78° < $\gamma_{fcc}$. Diese Tatsache hindert daran, den inneren Winkel $\gamma_{fcc}$ **12** und überhaupt alle Winkel $\gamma > \gamma_{Grenz}$ zwischen dem Referenzstrahl und den Nebenstrahlen im Inneren des Photolackes bei direkter Einstrahlung aus Luft zu realisieren. Daher sind Strukturen mit fcc-Translationssymmetrie und beispielsweise auch mit einfach kubischer (sc) Translationssymmetrie ($\gamma_{sc}$ = arccos(($\sqrt{3}$)/6) ≈ 73, 22°) in dieser Konfiguration durch Belichtung direkt aus Luft nicht herstellbar.

Für das Ausführungsbeispiel wurden kommerziell erhältliche Negativ-Photolacke verwendet, z.B. der Photolack SU-8. Diese wurden auf Glassubstrate (Durchmesser 25 mm, Dicke 5-7 mm) mit einer Lackschleuder aufgebracht (Spincoating). Damit erreichte man Schichtdicken von ca. 10 bis 50 $\mu$m. Um das Lösungsmittel weitgehend zu entfernen, wurde die Probe anschließend für ca. 1 Stunde auf 65° C erwärmt (soft bake).

Die nachfolgende Belichtung im Mehrstrahl-Interferenz-Aufbau erfolgte in der regenschirmartigen Anordnung (umbrella-like configuration). Die vier zueinander kohärenten Strahlen wurden durch Aufteilung des Strahles eines Lasers mittels Strahlteilern erhalten. Geeignet hierfür ist beispielsweise ein gütegeschalteter, frequenzverdreifachter (355 nm Wellenlänge), durch seeding longitudinal einmodiger Nd :YAG-Pulslaser. Durch die Impulsdauer von ca. 6 ns wurde Verwackelungsinschärfe vermieden. Vorteilhaft ist es, wenn sich die Intensität und die Polarisation jedes Teilstrahles getrennt voneinander einstellen lassen. Dies bedeutet insbesondere, dass die Strahlen unabhängig voneinander elliptisch, zirkular oder linear polarisiert eingerichtet werden können. Eine besondere Ausgestaltung besteht darin, dass der Referenzstrahl zirkular und die drei Nebenstrahlen linear, und zwar in ihrer jeweiligen Einfallsebene (sog. p-Polarisation) polarisiert sind. Das Verhältnis der Strahlenergien betrug 1,5:1:1:1 für Referenzstrahl : Nebenstrahl Nr. 1 : Nebenstrahl Nr. 2 : Nebenstrahl Nr. 3.

Mit diesen Strahlen wurde der Photolack mit einem einzelnen Laser-Impuls belichtet. Die für diese Belichtung notwendige Impulsenergie betrug vor der Aufteilung in vier Teilstrahlen ca. 8 mJ. Bei einer Strahl-Querschnittsfläche von ca. 1/2 cm$^2$ betrug die über den Querschnitt des Laserstrahls gemittelte Energie pro Fläche ca. 16 mJ/cm$^2$. Dies führte zu einem Füllfaktor der Strukturen von ca. 50%.

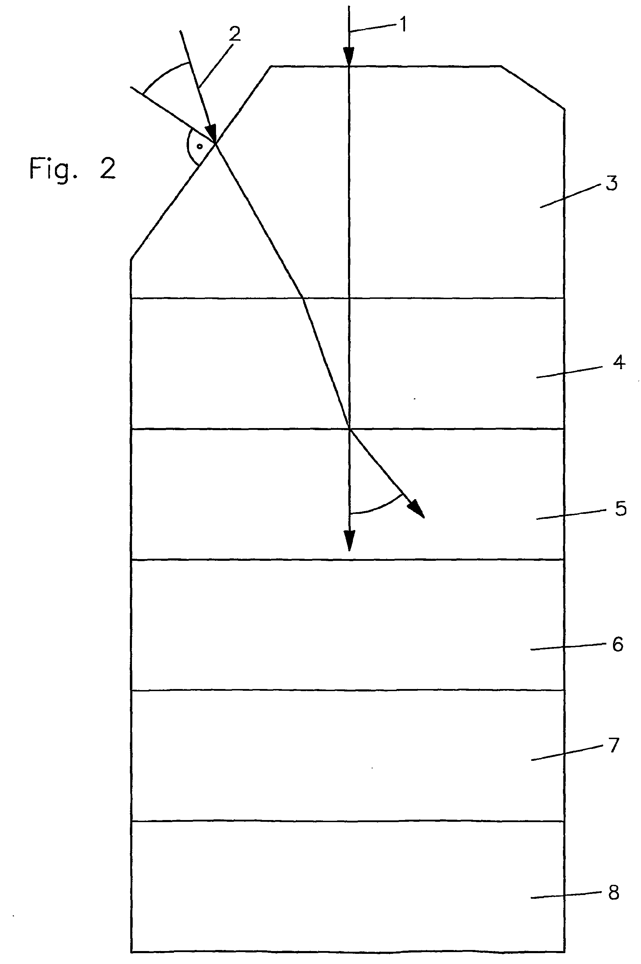

Um eine Struktur mit fcc-Translationssymmetrie im Photolack zu generieren, muss der halbe Öffnungswinkel $\gamma$ des Kegels im Innern des Photolackes die Bedingung $\gamma$ = arccos (7/9) ≈ 38,94° erfüllen. Dieser Winkel wird erfindungsgemäß durch Vorschalten eines speziell ausgeführten Vielflächners erreicht: Hierfür wurde ein modifizierter Retroreflektor, bei dem die Spitze abgetrennt und die Schnittfläche poliert wurde, verwendet (Pyramidenstumpf). Die Strahlführung ist in **Fig. 2** dargestellt.

Die Lichtstrahlen **1**, **2** werden vom optischen Element **3**, das als Einkoppel-Prisma ausgestaltet ist, über eine Immersionssubstanz **4** aus destilliertem Wasser in das Photolackvolumen **5** geleitet, das in diesem Ausführungsbeispiel auf einem Glassubstrat **6** aufgebracht ist. Um Rückreflexe von der Unterseite des Substrates **6** zu unterdrücken, schließt ein schwarz eloxiertes Aluminiumblech als Absorber **8** den Strahlengang ab. Zwischen Substrat **6** und Absorber **8** befindet sich eine weitere Immersionssubstanz **7** aus Öl. Ohne diese Auskoppel-Maßnahmen würden an der Unterseite des Substrats der Referenzstrahl **1** teilweise und die anderen drei Strahlen **2** total reflektiert und sich der Interferenz störend überlagern.

Der mit dem Interferenzmuster belichtete Photolack wurde zur Polymerisation für ca. 6 Minuten erwärmt, wobei die Temperatur von ca. 65° C auf ca. 92° C anstieg (post exposure bake). Nach dem Herausnehmen aus dem Ofen und Abkühlung ließ man die Probe für mindestens 30 Minuten ruhen.

Die Proben wurden zur Entwicklung für ca. 30 Minuten bis ca. 1 Stunde in einem Bad mit SU-8-Entwickler, der 1-Methoxy-2-propylacetat enthielt, ruhend stehen gelassen. Durch den Entwicklungsprozess wurden die schwach belichteten Bereiche des Photolacks im Entwickler aufgelöst; die stärker belichteten hingegen blieben stehen (SU-8 ist ein sog. "negativer" Photolack). Ein ca. zehnminütiges Bad in 2-Propanol schloss den Entwicklungsprozess ab.

Die Proben zeigen Risse, die wegen der ungleichmäßigen Volumenänderung (Quellung bzw. Schrumpfung) während des Entwicklungsprozesses auftreten. Manchmal löst sich die Probe ganz oder teilweise vom Substrat; Template stehen dann auch substratfrei zur Verfügung. Die Fläche der resultierenden Bruchstücke beträgt ca. 1 mm². Form und Größe der Bruchstücke kann durch gezieltes Einbringen von Ritzen in den Photolack (als Soll-Bruchstellen) kontrolliert werden.

Durch Verwendung eines positiven an Stelle eines negativen Photolackes erhält man die jeweils invertierte Struktur, die sich bei Verwendung eines negativen Lackes ergeben würde.

Ein gezieltes zerstörungsfreies Ablösen des Templats vom Substrat erreicht man durch Einbringen in ein Bad mit erwärmter oder kochender Salzsäure.

Eine weitere vorteilhafte Ausgestaltung der Erfindung ist die Belichtung des Photolacks durch das Glassubstrat hindurch. Hierzu wird das Substrat **6** einschließlich des hierauf mittels Spincoating aufgebrachten Photolackvolumens **5** umgedreht. Die Einstrahlung erfolgt von der sehr ebenen Seite des Photolacks, der auf dem Substrat **6** perfekt aufliegt, anstatt von der freien, im Allgemeinen weniger perfekten abgewandten Oberfläche der Photolackschicht.

Alle Teilstrahlen erfahren beim Eintritt aus dem äußeren Medium (z. B. Luft) in das Prisma mehr oder weniger starke Reflexionsverluste, die dadurch vermieden werden, dass alle Eintrittsflächen mit für den Einfallswinkel und die jeweilige Polarisation geeigneten Antireflexschichten versehen werden.

Für einen gegebenen inneren Winkel im Photolack und den hiervon (wegen der im Allgemeinen anderen Brechzahl) abweichenden Winkel im Prisma werden in einer besonders vorteilhaften Ausgestaltung die schräg stehenden Eintrittsflächen so orientiert hergestellt, dass die Strahlen gerade bei senkrechtem Eintritt in die Seitenflächen des Prismas den gewünschten Winkel im Photolack ergeben. Auf diese Weise lässt sich die korrekte Einstrahlrichtung besonders leicht und genau kontrollieren, weil der (auch bei Antireflex-Beschichtung vorhandene) restliche Rückreflex als Indikator genutzt werden kann: Die Reflexion eines Strahles in sich (Retroreflexion) ist besonders einfach verifizierbar. Außerdem ergibt sich eine Antireflex-Beschichtung unabhängig von der Strahlpolarisation.

In einer weiteren vorteilhaften Ausgestaltung werden die Immersionssubstanz und das Material, aus dem das Prisma besteht, so gewählt, dass sie die gleiche Brechzahl wie der Photolack haben. Dadurch werden auch geringe Rückreflexe vermieden und die Einkoppeleffizienz erhöht.

In einer weiteren Ausgestaltung werden die seitlichen Eintrittsflächen gerade so orientiert, dass sie bei korrekter Justierung bezüglich der eintretenden Strahlen unter dem Brewster-Winkel stehen. Hierdurch lässt sich die korrekte Einstellung des Winkels sehr präzise als Verschwinden der Reflexion des p-Anteils des Strahles erkennen.

In einer weiteren Ausgestaltung werden alle vier Strahlen parallel zueinander eingerichtet, wobei sie jedoch gegeneinander seitlich versetzt sind. Die Eintrittsflächen des Prismas werden so orientiert, dass sich die erforderlichen Winkel durch Brechung beim Eintritt in das Prisma ergeben. Die erforderliche Parallelität der Strahlen lässt sich mit hoher Genauigkeit beispielsweise durch Strahlteiler aus planparallelen Platten geeigneter Dicke verwirklichen. Die Aufgabe zur präzisen Winkeleinstellung zwischen den vier Strahlen wird auf diese Weise fast vollständig auf die sehr gut beherrschte Herstellung berechneter Winkel bei der Prismenfertigung übertragen.

Anstelle eines Absorbers **8** wird in einer weiteren vorteilhaften Ausgestaltung ein weiteres Prisma, das identisch mit dem für die Einkopplung verwendeten Prisma sein kann, zum Auskoppeln derjenigen Lichtstrahlen, die den Photolack und das Substrat bereits durchlaufen haben, verwendet. Die ausgekoppelten Strahlen stehen dann für weitere Analysen zur Verfügung, etwa für die Kontrolle der Polarisationszustände der Strahlen.

Eine weitere vorteilhafte Ausgestaltung der Strahlkonfiguration besteht darin, den Laserstrahl in vier Teilstrahlen aufzuteilen, wobei die Wellenvektoren von zwei Strahlen in einer Ebene liegen und die Wellenvektoren der beiden anderen Strahlen in einer weiteren Ebene, die senkrecht zur ersten Ebene steht. Das Wellenpaar, deren Wellenvektoren in der ersten Ebene liegen, propagiert dabei gegenläufig zu dem Wellenpaar in der anderen Ebene (K. I. Petsas et al., PRA 1994, 50, Seite 5173). Die Winkelhalbierende zwischen zwei Teilstrahlen ist beiden Paaren gemeinsam und bildet gleichzeitig das Lot zur Photolackschicht.

Das folgende Beispiel von vier Richtungsvektoren für die Wellenpropagation ergibt in der obigen Konfiguration eine fcc-Struktur:

[2,0,1], [-2,0,1], [0,2,-1], [0,-2,-1].

Die Photolackschicht wird von zwei Seiten, d.h. aus zwei Halbräumen, die durch die Photolackschicht voneinander getrennt sind, belichtet. Der innere Winkel der Strahlen zum Lot der Photolackschicht beträgt dann jeweils $\gamma_{fcc} = 0.5 * arccos(-3/5) \approx 63,43°$. Dieser Winkel im Inneren des Photolackes ist bei direkter Einstrahlung aus Luft nicht zu erreichen.

Daraus ergibt sich, dass die Strahlen von einem Halbraum in den Photolack eingekoppelt werden müssen und die Strahlen aus dem anderen Halbraum kommend ausgekoppelt werden müssen. Dies wird dadurch erreicht, dass die Photolackschicht zwischen zwei Dachprismen liegt, wobei die Dachflächen nach außen zeigen und die Prismen um 90° gegen einander verdreht sind. Jedes dieser Dachprismen dient für das eine Strahlenpaar als Einkopplungselement und für das andere als Auskopplungselement. Dies geschieht durch Abschrägen (Modifizieren) der senkrechten Seitenflächen der Prismen zu Pyramiden. Durch jedes dieser modifizierten Dachprismen tritt das eine Strahlenpaar ein und das andere Strahlenpaar aus. Um das Licht ein- und wieder auszukoppeln braucht man zwischen dem modifizierten Dachprisma und der Photolack-Schicht bzw. dem Substrat je eine Schicht aus einer geeigneten Immersionssubstanz 4, 7.

In einer weiteren Ausgestaltung werden während der Belichtung Bereiche des Photolacks gezielt abgedeckt (Maskierung), so dass nur Teile des Interferenzmusters im Photolack konserviert werden. Dadurch erhält man beispielsweise Template wählbarer Randform. Dieses Vorgehen ist sowohl bei positiven als auch bei negativen Photolacken von Interesse, weil die unbelichteten - d. h. die durch die Maskierung abgedeckten - Teile entweder stehen bleiben bzw. aufgelöst werden.

Durch eine strukturierte Vor- oder Nachbelichtung des Photolacks etwa mittels konventioneller Maskentechnik kann der Photolack in einer weiteren vorteilhaften Ausgestaltung in bestimmten Bereichen überbelichtet werden. Danach wird die oben beschriebene Vielstrahl-Interferenztechnik auch auf die noch unbelichteten Partien angewendet. Bei einem negativen Photolack bilden die überbelichteten Bereiche Vollmaterial. So entsteht ein Photolacktemplat, das von Vollmaterial umgeben ist. Dies ermöglicht eine bessere Handhabung des resultierenden Photolacktemplates, insbesondere dann, wenn die gesamte Photolackschicht vom Substrat abgelöst wird. Durch Wechsel zu positivem Photolack sind jeweils komplementäre Strukturen realisierbar.

Auf eine Schicht negativen Photolacks z. B. aus SU-8, die durch eine UV-Lampe vollständig überbelichtet und danach wahlweise entwickelt wurde (passivierte Haftschicht), kann man in einer weiteren Ausgestaltung eine weitere Photolack-Schicht zum Beispiel ebenfalls aus SU-8 aufbringen, die dann mit einem Interferenzmuster belichtet wird. Nach der Entwicklung dieser Schicht, die auf der Haftschicht liegt, erhält man ein Templat, das nach Ablösung vom Substrat auf einer Vollmaterial-Schicht aus Photolack (Haftschicht) liegt. Diese Haftschicht bildet dann ein Substrat von geringer Dicke, das die gleiche chemische Zusammensetzung aufweist wie die Photolack-Struktur.

Wegen der Absorption des Lichtes bei Propagation durch den Photolack ergibt sich eine Abnahme der Lichtintensität längs der Propagationsrichtung und damit in einer weiteren Ausgestaltung die Möglichkeit einer Variation des Füllfaktors mit der Tiefe (Verlaufs-Struktur). Durch geeignete Zusätze zum Photolack und/ oder durch das Auftragen mehrerer Schichten verschiedener Lacke, deren Lichtempfindlichkeiten sich voneinander unterscheiden, kann die Absorption und damit die tärke der Variation mit der Tiefe beeinflußt werden.

mgekehrt führt eine Vermeidung der Absorption etwa durch Reinigung it Entfernung absorbierender Beimischungen zu einer homogeneren Struktur der Photolackstruktur.

Die Strahlen fallen schräg in den Photolack ein. Dadurch ist der effektive Strahlquerschnitt anders als derjenige des ursprünglichen zum Beispiel runden Strahls. Eine bessere Überlappung aller Strahlen erreicht man dadurch, dass man diese mit bekannten optischen Elementen wie etwa mit anamorphischen Prismenpaaren in ihrem Querschnitt derart vor-verformt, dass sie durch den schrägen Einfall effektiv kreisförmig werden.

Bei Ausbreitung des Referenzstrahles in die entgegen gesetzte Richtung im Vergleich zur umbrella-like-Konfiguration erhält man andere Strukturen, insbesondere Spiralstrukturen.

Eine spezielle Ausgestaltung des erfindungsgemäßen Verfahrens besteht darin, nur drei Strahlen zu verwenden. Dadurch lassen sich zweidimensional periodische Photolack-Strukturen erzeugen. Mit Hilfe eines erfindungsgemäßen Einkoppelprismas lassen sich größere Winkel zwischen den Strahlen im Photolackvolumen realisieren und damit kleinere Gitterkonstanten als bei direkter Einstrahlung aus Luft.

## Patentansprüche

1. Verfahren zur Herstellung von Photolackstrukturen, bei dem ein Photolackvolumen (5) mit mindestens drei Lichtstrahlen, die einander innerhalb des Photolackvolumens (5) überlagern, mindestens einmal belichtet wird und danach einem Entwicklungsprozess unterworfen wird, wobei die Lichtstrahlen durch mindestens ein transparentes optisches Element (3) laufen, wobei das optische Element (3) ein Vielflächner mit ebenen oder gekrümmten Flächen ist.

2. Verfahren zur Herstellung von Photolackstrukturen nach Anspruch 1, **dadurch gekennzeichnet, dass** mindestens zwei Belichtungen des Photolackvolumens (5) vorgesehen sind, zwischen denen die Lichtstrahlen und das Photolackvolumen (5) relativ zueinander bewegt werden.

3. Verfahren zur Herstellung von Photolackstrukturen, bei dem ein Photolackvolumen (5) mit mindestens zwei Lichtstrahlen (1, 2), die einander innerhalb des Photolackvolumens (5) überlagern, mindestens zweimal belichtet wird, wobei zwischen den mindestens zwei Belichtungen des Photolackvolumens (5) die Lichtstrahlen (1, 2) und das Photolackvolumen (5) relativ zueinander bewegt werden, und danach einem Entwicklungsprozess unterworfen wird, wobei die Lichtstrahlen (1, 2) durch mindestens ein transparentes optisches Element (3) laufen, wobei das optische Element (3) ein Vielflächner mit ebenen oder gekrümmten Flächen ist.

4. Verfahren zur Herstellung von Photolackstrukturen nach einem der Ansprüche 1 bis 3, **dadurch gekennzeichnet, dass** als Vielflächner ein Teilprisma mit ebenen Flächen verwendet wird.

5. Verfahren zur Herstellung von Photolackstrukturen nach Anspruch 4, **dadurch gekennzeichnet, dass** als Teilprisma eine Pyramide verwendet wird.

6. Verfahren zur Herstellung von Photolackstrukturen nach Anspruch 4, **dadurch gekennzeichnet, dass** als Teilprisma ein Pyramidenstumpf verwendet wird.

7. Verfahren zur Herstellung von Photolackstrukturen nach einem der Ansprüche 1 bis 3, **dadurch gekennzeichnet, dass** als Vielflächner ein Kugelabschnitt verwendet wird.

8. Verfahren zur Herstellung von Photolackstrukturen nach einem der Ansprüche 1 bis 7, **dadurch gekennzeichnet, dass** das Photolackvolumen (5) direkt auf einem der optischen Elemente (3) aufgebracht ist.

9. Verfahren zur Herstellung von Photolackstrukturen nach einem der Ansprüche 1 bis 8, **dadurch gekennzeichnet, dass** zwei optische Elemente eingesetzt werden, zwischen denen sich das Photolackvolumen (5) befindet.

10. Verfahren zur Herstellung von Photolackstrukturen nach einem der Ansprüche 1 bis 9, **dadurch gekennzeichnet, dass** sich zwischen mindestens einem der optischen Elemente (3) und dem Photolackvolumen (5) eine Immersionssubstanz (4) befindet.

11. Verfahren zur Herstellung von Photolackstrukturen nach einem der Ansprüche 1 bis 10, **dadurch gekennzeichnet, dass** die Lichtstrahlen (1, 2) hinsichtlich ihrer Intensität, Phase und Polarisation unabhängig voneinander eingerichtet sind.

12. Verfahren zur Herstellung von Photolackstrukturen nach einem der Ansprüche 1 bis 11, **dadurch gekennzeichnet, dass** einzelne Bereiche auf der Oberfläche des Photolackvolumens (5) mit mindestens einer Schattenmaske abgedeckt sind.

13. Verfahren zur Herstellung von Photolackstrukturen nach einem der Ansprüche 1 bis 12, **dadurch gekennzeichnet, dass** das Photolackvolumen (5) zusätzlich mit einem einzelnen Strahl belichtet wird.

14. Verfahren zur Herstellung von Photolackstrukturen nach einem der Ansprüche 1 bis 13, **dadurch gekennzeichnet, dass** das Photolackvolumen (5) in Segmente zerlegt ist.

15. Verfahren zur Herstellung von Photolackstrukturen nach einem der Ansprüche 1 bis 14, **dadurch gekennzeichnet, dass** das Photolackvolumen auf ein weiteres mit mindestens einem Strahl belichtetes Photolackvolumen aufgebracht ist.

**Claims**

1. Method for the production of photoresist structures, in which a photoresist volume (5) is exposed at least once with at least three light beams which are superposed one on the other within the photoresist volume (5), and thereafter is subjected to a developing process, the light beams passing through at least one transparent optical element (3), the optical element (3) being a polyhedron with flat or curved faces.

2. Method for the production of photoresist structures according to claim 1, **characterised in that** at least two exposures of the photoresist volume (5) are provided, between which the light beams and the photoresist volume (5) are moved relative to each other.

3. Method for the production of photoresist structures, in which a photoresist volume (5) is exposed at least twice with at least two light beams (1, 2) which are superposed one on the other within the photoresist volume (5), the light beams (1, 2) and the photoresist volume (5) being moved relative to each other between the at least two exposures of the photoresist volume (5), and thereafter being subjected to a developing process, the light beams (1, 2) passing through at least one transparent optical element (3), the optical element (3) being a polyhedron with flat or curved faces.

4. Method for the production of photoresist structures according to one of the claims 1 to 3, **characterised in that** a partial prism with flat faces is used as polyhedron.

5. Method for the production of photoresist structures according to claim 4, **characterised in that** a pyramid is used as partial prism.

6. Method for the production of photoresist structures according to claim 4, **characterised in that** a truncated pyramid is used as partial prism.

7. Method for the production of photoresist structures according to one of the claims 1 to 3, **characterised in that** a spherical segment is used as polyhedron.

8. Method for the production of photoresist structures according to one of the claims 1 to 7, **characterised in that** the photoresist volume (5) is deposited directly on one of the optical elements (3).

9. Method for the production of photoresist structures according to one of the claims 1 to 8, **characterised in that** two optical elements are used, between which the photoresist volume (5) is situated.

10. Method for the production of photoresist structures according to one of the claims 1 to 9, **characterised in that** an immersion substance (4) is situated between at least one of the optical elements (3) and the photoresist volume (5).

11. Method for the production of photoresist structures according to one of the claims 1 to 10, **characterised in that** the light beams (1, 2) are established independently of each other with respect to their intensity, phase and polarisation.

12. Method for the production of photoresist structures according to one of the claims 1 to 11, **characterised in that** individual regions on the surface of the photoresist volume (5) are covered with at least one shadow mask.

13. Method for the production of photoresist structures according to one of the claims 1 to 12, **characterised in that** the photoresist volume (5) is exposed additionally with a separate beam.

14. Method for the production of photoresist structures according to one of the claims 1 to 13, **characterised in that** the photoresist volume (5) is divided into segments.

15. Method for the production of photoresist structures according to one of the claims 1 to 14, **characterised in that** the photoresist volume is deposited on a further photoresist volume which is is exposed with at least one beam.

## Revendications

1. Procédé de production de structures de laque photosensible, dans lequel un volume en laque photosensible (5) est éclairé au moins une fois avec au moins trois faisceaux lumineux qui se superposent à l'intérieur du volume en laque photosensible (5) et est ensuite soumis à un processus de développement, les faisceaux lumineux traversant au moins un élément optique transparent (3) et l'élément optique (3) étant un polyèdre avec des surfaces planes ou courbées.

2. Procédé de production de structures en laque photosensible selon la revendication 1, **caractérisé en ce qu'** il est prévu au moins deux éclairages du volume en laque photosensible (5), entre lesquels les faisceaux lumineux et le volume en laque photosensible (5) se déplacent relativement l'un à l'autre.

3. Procédé de production de structures en laque photosensible, selon lequel un volume en laque photosensible (5) est éclairé au moins deux fois avec au moins deux faisceaux lumineux (1, 2) qui se superposent à l'intérieur du volume en laque photosensible (5), les faisceaux lumineux (1, 2) et le volume en laque photosensible (5) se déplaçant relativement l'un à l'autre entre les au moins deux éclairages du volume en laque photosensible (5), et est ensuite soumis à un processus de développement, les faisceaux lumineux (1, 2) traversant au moins un élément optique transparent (3) et l'élément optique (3) étant un polyèdre avec des surfaces planes ou courbées.

4. Procédé de production de structures en laque photosensible selon l'une des revendications 1 à 3, **caractérisé en ce qu'** un prisme partiel avec surfaces planes est utilisé comme polyèdre.

5. Procédé de production de structures en laque photosensible selon la revendication 4, **caractérisé en ce qu'** une pyramide est utilisée comme prisme partiel.

6. Procédé de production de structures en laque photosensible selon la revendication 4,
**caractérisé en ce qu'**
une pyramide tronquée est utilisée comme prisme partiel.

7.  Procédé de production de structures en laque photosensible selon l'une des revendications 1 à 3,
    **caractérisé en ce qu'**
    un segment sphérique est utilisé comme prisme partiel.

8.  Procédé de production de structures en laque photosensible selon l'une des revendications 1 à 7,
    **caractérisé en ce que**
    le volume en laque photosensible (5) est appliqué directement sur l'un des éléments optiques (3).

9.  Procédé de production de structures en laque photosensible selon l'une des revendications 1 à 8,
    **caractérisé en ce qu'**
    on utilise deux éléments optiques entre lesquels se trouve le volume en laque photosensible (5).

10. Procédé de production de structures en laque photosensible selon l'une des revendications 1 à 9,
    **caractérisé par**
    une substance d'immersion (4) placée entre au moins un des éléments optiques (3) et le volume en laque photosensible (5).

11. Procédé de production de structures en laque photosensible selon l'une des revendications 1 à 10,
    **caractérisé en ce que**
    les faisceaux lumineux (1, 2) sont agencés indépendamment les uns des autres en ce qui concerne leur intensité, leur phase et leur polarisation.

12. Procédé de production de structures en laque photosensible selon l'une des revendications 1 à 11,
    **caractérisé en ce que**
    certaines zones de la surface du volume en laque photosensible (5) sont recouvertes d'au moins un masque d'ombre.

13. Procédé de production de structures en laque photosensible selon l'une des revendications 1 à 12,
    **caractérisé en ce que**
    le volume en laque photosensible (5) est éclairé en outre avec un faisceau individuel.

14. Procédé de production de structures en laque photosensible selon l'une des revendications 1 à 13,
    **caractérisé en ce que**
    le volume en laque photosensible (5) est décomposé en segments.

15. Procédé de production de structures en laque photosensible selon l'une des revendications 1 à 14,

**caractérisé en ce que**
le volume en laque photosensible est appliqué sur un autre volume en laque photosensible éclairé avec au moins un faisceau.

## Fig. 1

Fig. 2

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 3635540 A
- GB 1289095 A
- WO 0122133 A1

### In der Beschreibung aufgeführte Nicht-Patentliteratur

- **K. I. PETSAS et al.** *Phys. Rev.,* 1994, vol. 50, 5173
- **K. I. PETSAS et al.** *PRA,* 1994, vol. 50, 5173